# EUROPEAN PATENT SPECIFICATION

(11) **EP 1 912 443 B1**
(45) Date of publication and mention of the grant of the patent: **06.06.2012**
(21) Application number: 06742107.3
(22) Date of filing: 06.06.2006
(51) Int. Cl.: H04N 7/50, H04N 7/26

(54) **CONTEXT-BASED ADAPTIVE ARITHMETIC DECODING SYSTEM AND APPARATUS**
SYSTEM UND VORRICHTUNG ZUR ADAPTIVENARITHMETISCHEN DECODIERUNG AUF KONTEXTBASIS
SYSTEME ET APPAREIL DE DECODAGE ARITHMETIQUE ADAPTATIF BASE SUR LE CONTEXTE

(30) Priority: 04.08.2005 CN 200510088392
(43) Date of publication of application: 16.04.2008
(73) Proprietor: Huawei Technologies Co., Ltd., Longgang District, Shenzhen Guangdong 518129 (CN)
(72) Inventor: YANG, Kai, Shenzhen, Guangdong 518219 (CN); WANG, Lin, Shenzhen, Guangdong 518219 (CN); LIN, Bo, Shenzhen, Guangdong 518219 (CN); YU, Wei, Shenzhen, Guangdong 518219 (CN)
(74) Representative: Kreuz, Georg Maria
(86) International application number: PCT/CN2006/001221
(87) International publication number: WO 2007/014509

(56) References cited:
- WO-A1-03/091942
- CN-A- 1 224 978
- CN-A- 1 610 265
- US-A1- 2004 240 559
- US-B1- 6 229 463
- WEI YU ET AL: "A High Performance CABAC Decoding Architecture", IEEE TRANSACTIONS ON CONSUMER ELECTRONICS, IEEE SERVICE CENTER, NEW YORK, NY, US, vol. 51, no. 4, 1 November 2005 (2005-11-01), pages 1352-1359, XP002576043, ISSN: 0098-3063, DOI: DOI:10.1109/TCE.2005.1561867
- R.R. OSORIO; J.D. BRUGUERA: "Arithmetic coding architecture for H.264/AVC CABAC compression system", DIGITAL SYSTEM DESIGN, 2004. DSD 2004. EUROMICRO SYMPOSIUM, 31 August 2004 (2004-08-31), pages 62-69, XP10723482,
- JIAN-WEN CHEN ET AL: "A Hardware Accelerator for Context-Based Adaptive Binary Arithmetic Decoding in H.264/AVC", CONFERENCE PROCEEDINGS / IEEE INTERNATIONAL SYMPOSIUM ON CIRCUITS AND SYSTEMS (ISCAS) : MAY 23 - 26, 2005, INTERNATIONAL CONFERENCE CENTER, KOBE, JAPAN, IEEE SERVICE CENTER, PISCATAWAY, NJ, 23 May 2005 (2005-05-23), pages 4525-4528, XP010817170, DOI: DOI:10.1109/ISCAS.2005.1465638 ISBN: 978-0-7803-8834-5

## Description

### Field of the invention

The present invention relates to the field of video communication, and particularly to a context-based adaptive binary arithmetic decoding system and apparatus.

### Background of the invention

Context-based Adaptive Binary Arithmetic Coding (CABAC) is an entropy coding scheme. Compared with the other entropy coding scheme, i.e., Context-based Adaptive Variable Length Coding (CAVLC), CABAC provides better compression performance, but is more complex to implement.

An entropy coder is adapted to code the values of all syntax elements in every macroblock (MB) into a code stream in a fixed order according to the order of scanning the macroblocks. The macroblocks are the basic unit blocks for video coding, and every image in a video is divided into macroblocks before coding.

Binary arithmetic decoding corresponding to CABAC is implemented on the basis of the principle of recursive interval subdivision. When the present bin is decoded, a probability estimation, 0 or 1, of the bin is needed. The probability value is represented with a "p" and is decided on the basis of a context probability model corresponding to the present bin. The Most Probable Symbol (MPS) and the Least Probable Symbol (LPS), which correspond to 0 or 1 respectively, should be distinguished first. The value of LPS (vaILPS) is 1 and the value of MPS (valMPS) is 0, and both values are used for the context probability model corresponding to the bin being decoded at present. When valMPS corresponding to the present bin is expressed as p(0), the valLPS is expressed as p(1) = 1 - p(0).

The range of binary probability is (0,1), and the whole range is decided according to a codIRange value. The size of a sub-interval is calculated on the basis of the probability value p corresponding to the present bin decoded. Specifically, the MPS range corresponds to p(0)*codIRange and the LPS range corresponds to codIRange - p(0)*codIRange. When the probability range is decided, it can further be decided on the basis of the value of codlOffset that into which sub-interval the probability value of the present bin falls. If the probability value of the present bin falls into the LPS range, the value of the present bin will be valLPS. If the probability value of the present bin falls into the MPS range, the value of the present bin will be vaIMPS. When the probability value of the present bin falls into the MPS range, the MPS range p(0)*codIRange will be used as the whole range codIRange for range division and decoding of a next bin. The above description is just the basic principle of the CABAC decoding, and the detailed explanation of CABAC decoding is given in ITU-T Recommendation H.264 which is used as a reference to the description and will not be detailed.

In the maintenance of the context probability model, a group of Finite State Machines (FSMs) is used for probability estimation. The FSMs are based on a probability state table covering 64 different probability states:
{pLPS(pStateIdx)| 0<=StateIdx<64}

Every value in the table corresponds to a LPS value pLPS. The table is adapted in a way that the pLPS decreases as the pStateIdx increases. The pLPS equals 0.5 when pStateIdx = 0.

The CABAC algorithm is put forward in the JVT (ITU-T VCEG and ISO/IEC MPEG) meeting in 2003, and the algorithm has been developing for only a short period of time and there are few complete decoding application structures developed for the algorithm, especially high-speed and high-throughput real-time decoders.

The CABAC hardware decoding units ever disclosed work with either software decoders or software decoders in combination with hardware decoders.

The jm95 software provided by the JVT can be used for a reference to the CABAC software-hardware decoding units. When a software decoder decodes according to an algorithm flow on a PC, the software handles the whole CABAC decoding process and thus is too slow in decoding to satisfy the requirement of real-time applications.

R.R. Osorio and J.D. Bruguera suggested a hardware decoding unit architecture in "Arithmetic coding architecture for H.264/AVC CABAC compression system", Digital System Design, 2004. DSD 2004. Euromicro Symposium on, 31 Aug.-3 Sept. 2004 Page62-69, in which hardware decoding is adopted in combination with software decoding. The coefficient syntax element decoding, which constitutes most of the work in the decoding process, is achieved with hardware acceleration while other syntax elements, e.g., mb type, sub_mb_type, Coded Block Patterns (CBP), dquant luma prediction mode, chroma prediction mode, Motion Vector Data (MVD) and reference frame index, are decoded by software. Such decoder architecture provides much higher decoding efficiency than software-hardware decoding units, but such decoder architecture still has disadvantages as follows.
(1) The technical scheme enables the hardware to decode only one type of syntax element in the macroblock layer, i.e., the coefficient, and the software handles the decoding of all other syntax elements. The software and the hardware have to exchange not only information of the neighboring macroblock, but also the variables Range and Offset constantly during the decoding process as the variables are generated in the CABAC decoding process, therefore the functions of the software and the hardware cannot be divided clearly, the interaction process is complicated and the efficiency is still at a low level.
(2) The software decodes all other syntax elements but the coefficient syntax element while the hardware decodes only the coefficient syntax element, and the system resources are not used for further improving the system performance, but wasted to an extent.

To sum up, in the conventional technical scheme, the software decodes all or most of syntax elements in the macroblock layer, which provides low CABAC decoding performance and complex application, and further makes it hard to provide sufficient video processing speed and data processing capability for real-time and high definition applications.

US patent application 20040240559 discloses a CABAC decoding engine, which is devised to cover all aspects of decoding all CABAC-coded syntax elements for AVC. The CABAC decoding engine has the following highlights: unique context model retrieving and storing method is developed to allow a complete syntax element to be decoded in a hardware (H/W) execution cycle; H/W assisted approach is provided to accelerate context model initialization; H/W based approach is incorporated to allow fast de-binarization; H/W based approach is provided to allow a block of syntax elements to be decoded instead of one by one; and dedicated H/W accelerators are incorporated to decode special syntax elements.

Prior art in "A hardware accelerator for context-based adaptive binary arithmetic decoding in H.264/AVC" discloses an efficient memory system for easy integration and LDCT. A finite state machine is also disclosed. In the memory system, the coefficient is stored in memory of SRAM.

Prior art in "Arithmetic coding architecture for H.264/AVC CABAC compression system" discloses a memory for storing the context elements and a cache for buffering the context elements, e.g. coefficient syntax elements. The context elements can be read from the memory and buffered in the cache for decoding.

### Summary of the Invention

The present invention provides a context-based adaptive binary arithmetic decoding apparatus according to the appended claim.

### Brief description of the drawings

Figure 1 is a structure schematic of the decoding system according to the present invention.
Figure 2 is a structure schematic of the decoding unit in the decoding system.
Figure 3 is a composition diagram of the syntax elements decoded by the decoding unit according to the present invention.
Figure 4 is a status schematic of the mb_layer syntax elements decoded by the decoding unit according to the present invention.
Figure 5 is a structure schematic of the decoding unit according to the present invention.
Figure 6 is a flow chart of the decoding of P and B slice macroblocks.
Figure 7 is a flow chart of the decoding of an I slice macroblock.
Figure 8 is a structure schematic of the interface unit in the decoding system.

### Detailed description of the invention

The present invention is further described hereinafter in detail with reference to the accompanying drawings as well as embodiments so as to make the technical solution and merits more apparent. It should be appreciated that the embodiments are used for explaining the present invention only and are not used for limiting the protection scope of the present invention.

In the present embodiment, a neighboring macroblock or bins of the neighboring macroblock is used for calculating the context probability model value of the bin to be decoded presently. The corresponding context probability model value is selected from the Random-Access Memory (RAM) through a calculation flow. The value of the present bin is calculated through the calculation flow. The probability value, 0 or 1, of the present bin is updated accordingly. In other words, the context probability model value corresponding to the present bin is updated and written back to corresponding RAM space. The whole process shows that the CABAC decoding is a context-based arithmetic decoding method. The "context-based" means that, the possible value of a syntax element to be decoded is estimated on the basis of the values of decoded syntax elements, if the estimation is accurate, the present syntax element can be decoded with little bit consumption or even without bit consumption so that the bitstream compression ratio is improved.

According to the technical scheme described above, the present embodiment provides a CABAC decoding apparatus for decoding all CABAC syntax elements with hardware. All associated variables for CABAC decoding including the parameters range and offset and the ever updating context probability model of the bins are maintained by the CABAC decoding apparatus.

In the CABAC decoding system, software is adapted to control the decoding process of the decoding apparatus. However, the software just provides information of a neighboring macroblock, bitstreams and control signals without participating in the CABAC data maintenance and decoding process. The interactions between the software and the hardware include bitstream data interaction, configuration information interaction and decoding result data acquirement on the basis of macroblock layer.

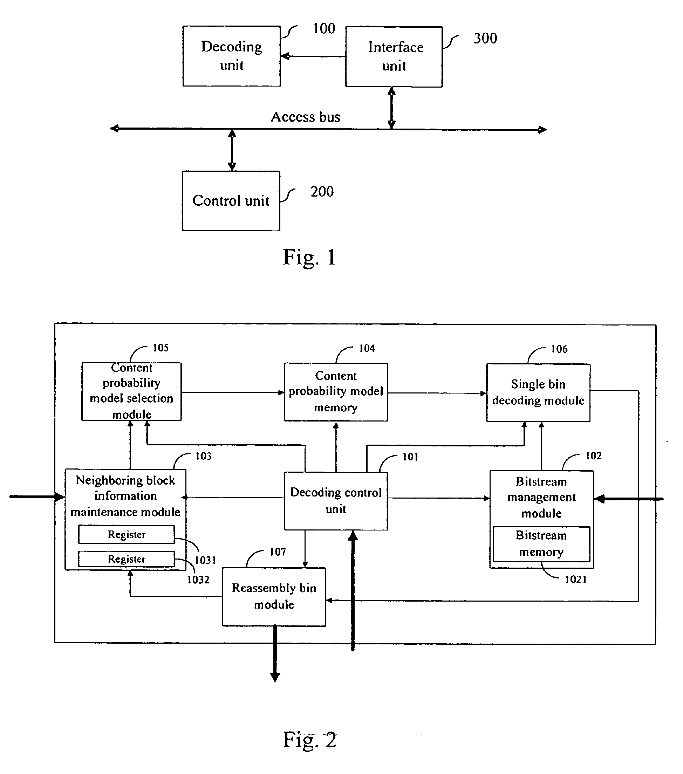

Figure 1 shows the structure of the CABAC decoding system according to the present invention. The system consists of three parts: decoding unit 100 for CABAC decoding, control unit 200 for configuring and controlling decoding unit 100, and interface unit 300. Control unit 200 exchanges data with interface unit 300 and controls the decoding unit 100 to decode via an access bus. Decoding unit 100 is the main body of the CABAC decoding system and is adapted to decode all syntax elements in the macroblock layer. Control unit 200 sends decoding control signals and bitstreams to be decoded to decoding unit 100 via interface unit 300. Decoding unit 100 sends the decoded data to control unit 200 via interface unit 300.

Figure 2 shows the structure of decoding unit 100.

Decoding unit 100 further includes decoding control unit 101, a decoding management unit and a decoding information management unit.

Decoding control unit 101 connects the decoding management unit and the decoding information management unit, and is adapted to receive a decoding control signal from control unit 200 and send the decoding control signal to the decoding management unit and the decoding information management unit for decoding all syntax elements in the bitstreams.

The decoding management unit is adapted to receive the decoding control signal from the control unit 200, and decode in the macroblock layer all syntax elements of the bitstreams filled into decoding unit 100.

The decoding information management unit is adapted to save context probability models, selecting a context probability model on the basis of information of the neighboring macroblock and information of the present macroblock for decoding a bin in the present syntax elements, and sending the selected context probability model to the decoding management unit for decoding process.

The decoding management unit may include bitstream management module 102, single bin decoding module 106 and reassembly bin module 107.

The decoding information management module includes context probability model selection module 105, context probability model memory 104 and neighboring macroblock information maintenance module 103.

In practical applications, single bin decoding module 106 and context probability model selection module 105 are combined circuits while other modules are sequential circuits, and the whole decoding unit 100 is digital circuits integrated on an integrated circuit chip.

Decoding control unit 101 controls the decoding processes of all the other modules in the decoding unit 100 by sending decoding control signals to the modules to arrange the works of the modules. Decoding control unit 101 includes a control state machine to decode syntax elements in the whole macroblock layer by controlling different decoding states.

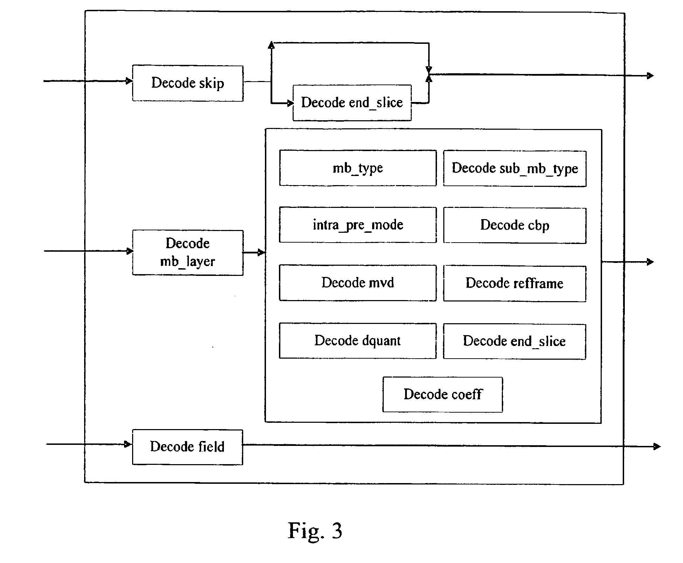

Figure 3 shows three decoding control processes of the control state machine in the decoding control unit 101, i.e., the skip state decoding control process, the field state decoding control process and the mb_layer state decoding control process. Figure 3 includes all syntax elements encoded and decoded with CABAC in the main profile of Recommendation H.264, in which
(1) Skip indicates that a macroblock should be skipped in a P slice;
(2) End_slice is an indication showing that the present macroblock is the last macroblock in the slice layer;
(3) mb_type indicates the type of the present macroblock, and sub_mb-type indicates four 8×8 blocks in a macroblock;
(4) Intra_pre_mode indicates the luma prediction mode and chroma prediction mode while decoding a macroblock of type 4x4 when the macroblock is an intra block;
(5) Cbp is the coefficient existence flag of the present macroblock;
(6) Dquant is the quant difference of the present macroblock;
(7) Mvd is the motion vector difference flag of the present macroblock;
(8) Refframe is the reference frame flag of the present macroblock;
(9) Coeff is the coefficient flag of the present macroblock;
(10) Field is the field pattern flag of the present macroblock.

According to the present embodiment, the skip decoding and field decoding are separated from the decoding in the mb_tayer to improve the decoding efficient and reduce the interaction overhead of the software and the hardware. The three decoding processes, i.e., the skip decoding, field decoding and the mb_layer decoding, can be controlled separately by control unit 200 in decoding of corresponding syntax elements.

The mb_layer decoding includes the decoding of 9 syntax elements and is the main part of the CABAC decoding process. In the mb_layer, 9 syntax elements are decoded in an order in accordance with Recommendation H.264. JVT-G050, "Draft ITU-T Recommendation H.264 and Draft ISO/IEC 14496-10 AVC" in JVT of ISO/IEC doc, T.Wig,Ed.,Pattaya, Thailand, Mar.2003 is used as a reference to the present invention and will not be detailed. When the skip value is I in the skip decoding, the end_slice syntax element will be decoded and the process will be terminated; when the skip value is 0 in the skip decoding, the process will be terminated directly and decoding unit 100 proceeds to the next step of decoding.

According to the present embodiment, the skip decoding is separated from the mb_layer decoding process, because the configuration information for the skip decoding is little while the mb_layer decoding needs a lot of configuration information. When a macroblock is a skip macroblock, the mb_layer decoding need not be started and the decoding of the macroblock can be completed with little configuration information, which is economical.

Field decoding is optional, and the field syntax element is separated from other syntax elements in decoding because the field decoding process selects a neighboring macroblock in a way different from the way the mb skip decoding and the mb_layer layer syntax element decoding processes select a neighboring macroblock, it will be better to set up a separate software-hardware interaction pattern for the field decoding.

According to another embodiment, the skip decoding and the field decoding can be combined into the mb_layer decoding process, or the decoding of some other syntax elements can be separated from the mb_layer decoding process and be controlled separately by control unit 200.

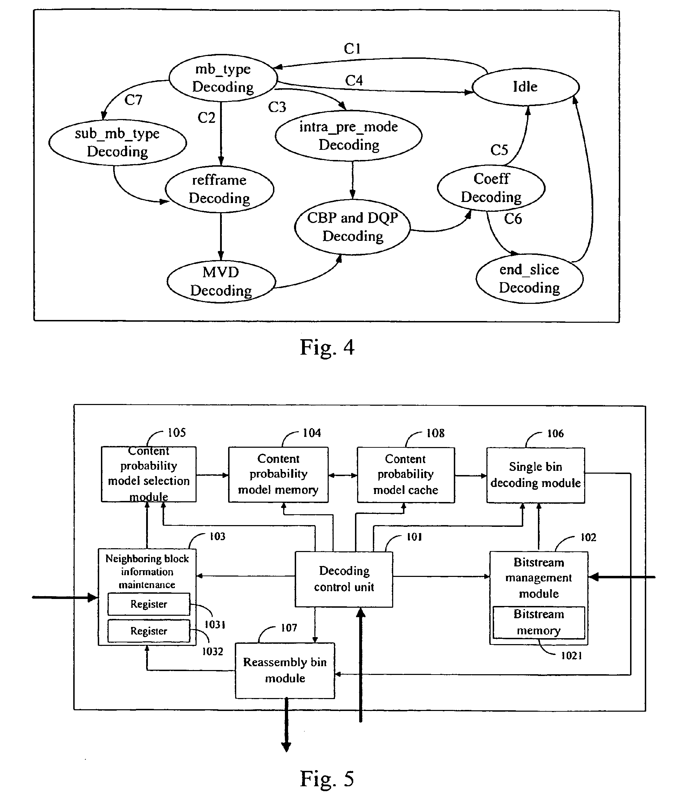

Figure 4 shows the state control flow in the decoding of mb_layer syntax elements performed by decoding unit 100 under the control of decoding control unit 101. In the decoding of the mb_layer syntax elements, the initial state of decoding unit 100 is idle, and upon receipt of a valid mb_layer decoding start signal (C1), decoding unit 100 starts mb_ layer decoding.

When decoding unit 100 completes the decoding of mb_type, for a P macroblock or B macroblock in a division pattern other than four 8×8 blocks (C2), the decoding process proceeds according to the following order: the refframe decoding, mvd decoding, cbp and dqp decoding, coeff decoding; for an I macroblock in a decoding mode which is not an I_PCM decoding mode (C3), the decoding process proceeds according to the following order: cbp and dqp decoding, coeff decoding; for an I macroblock in the decoding mode of I_PCM (C4), decoding unit 100 returns to idle state; and for a P macroblock or B macroblock in four 8×8 blocks (C7), the decoding process proceeds according to the following order: sub_mb_type decoding, refframe decoding, mvb decoding, cbp and dqp decoding, coeff decoding.

When the coeff decoding is completed, if the decoding process is in the mbaff decoding mode and the number of the macroblock to be decoded at present in an even number (C5), decoding unit 100 will return to idle; if the decoding process is not in the mbaff decoding mode, or if the decoding process is in the mbaff decoding mode but the number of the macroblock to be decoded at present in an odd number (C6), the decoding process proceeds to send_slice decoding before decoding unit 100 returns to idle.

Bitstream management module 102 receives bitstreams and sends the bitstreams to single bin decoding module 106. Bitstream management module 102 includes bitstream memory 1021, adapted to provide bitstreams for single bin decoding module 106. When the bitstreams in bitstream memory 1021 is about to be exhausted, bitstream management module 102 sends a bitstream loading request to control unit 200.

In the macroblock decoding process, when the bitstreams in bitstream memory 1021 are exhausted, bitstream management module 102 sends a bitstream filling request to control unit 200 and suspends the decoding process until control unit 200 fills the needed bitstreams into the memory.

Neighboring macroblock information maintenance module 103 maintains the information of a neighboring macroblock. The information of the neighboring macroblock includes the information of a macroblock to the left of the present macroblock and a macroblock above the present macroblock. Neighboring macroblock information maintenance module 103 includes two groups of registers, register 1031 and register 1032, adapted to store the information of the macroblock to the left of the present macroblock and the information of the macroblock above the present macroblock respectively. The information of the neighboring macroblock indicates whether the neighboring macroblocks are valid, whether the neighboring macroblocks should be skipped, the slice field mode of the neighboring macroblocks and the neighboring decoded syntax elements. When a syntax element in the present macroblock is decoded, the probability model corresponding to the first bin of the syntax element usually need be selected on the basis of the decoded syntax elements in the neighboring macroblocks, therefore the neighboring macroblock information maintenance module 103 need provide context probability model selection module 105 with information of the neighboring macroblock needed for probability model selection.

According to an embodiment, the information of the neighboring macroblock of the present macroblock is maintained solely by control unit 200 and control unit 200 sends the information of the neighboring macroblock to neighboring macroblock information maintenance module 103 via interface unit 300, however, the embodiment has a comparatively complicated interaction flow for the software-hardware decoding process.

According to another embodiment, the syntax element information of a neighboring macroblock is maintained by neighboring macroblock information maintenance module 103 in decoding unit 100, which makes a simple software-hardware interaction flow; however, neighboring macroblock information maintenance module 103 will consume too many resources to maintain the information of the neighboring macroblock to the left of the present macroblock and the information of the neighboring macroblock above the present macroblock.

According to a preferred embodiment, control unit 200 maintains syntax element information of a neighboring macroblock above the present macroblock. Neighboring macroblock information maintenance module 103 maintains syntax element information of a neighboring macroblock to the left of the present macroblock. In this way the software-hardware interaction is simple and the resources are consumed only for maintaining the syntax element information of one or two (in mbaff mode) neighboring macroblocks to the left of the present macroblock.

Context probability model memory 104 is a RAM adapted to store all probability models needed by all syntax elements. Context probability model memory 104 stores all together 399 probability models, which include all the probability model information needed for decoding all syntax elements in the whole macroblock layer.

Context probability model selection module 105 stores probability model selection policies for all bins of all syntax elements, and is adapted to select a probability model for a bin in the present syntax element. The result sent by context probability model selection module 105 is like a pointer indicating which probability model single bin decoding module 106 should select from context probability model memory 104 for each bin of the present syntax element which is being decoded. The rules for probability model selection include: first, the syntax element being decoded at present; second, the bin being decoded in the syntax element; and third, the values of syntax elements corresponding to neighboring macroblocks. The rules for probability model selection are described in Recommendation H.264, and JVT-G050, "Draft ITU-T Recommendation H.264 and Draft ISO/IEC 14496-10 AVC" in JVT of ISO/IEC doc, T.Wig,Ed.,Pattaya, Thailand, Mar.2003 can be used as a reference to the present invention and will not be detailed.

Single bin decoding module 106 is adapted to decode bins of every syntax element, and the decoding algorithm adopted is the standard CABAC decoding algorithm in Recommendation H.264; JVT-G050, "Draft ITU-T Recommendation H.264 and Draft ISO/IEC 14496-10 AVC" in JVT of ISO/IEC doc, T.Wig,Ed.,Pattaya, Thailand, Mar.2003 can be used as a reference to the present invention and will not be detailed. The bitstreams needed in the decoding process are obtained from bitstream management module 102 and the needed probability models are obtained from context probability model cache 108. The decoding result from single bin decoding module 106 is sent to reassembly bin module 107 for re-constructing syntax elements.

Because single bin decoding module 106 decodes only one bin at a time in a syntax element, and a bin reassembly process is needed to restore a needed syntax element from the result of decoding bin. Reassembly bin module 107 is adapted to assemble syntax elements. Different syntax elements should be assembled in different ways on the basis of the type of the present decoded syntax element in accordance with the assembly rules described in Recommendation H.264. After the assembling of syntax elements, reassembly bin module 107 sends the decoded syntax elements to control unit 200 and sends information of the syntax elements of the neighboring macroblock needed for the fol low-up decoding process to neighboring macroblock information maintenance module 103 for the reference to the follow-up decoding process of syntax elements.

In the above embodiment, single bin decoding module 106 directly selects a needed probability model from context probability model memory 104 and the selecting and updating of probability model will affect decoding efficiency due to the limit of RAM access. According to a preferred embodiment, as shown in Figure 5, the probability model needed for decoding a type of syntax element is accessed by context probability model cache 108. Context probability model cache 108 is a high-speed cache adapted to invoke context probability models for single bin decoding module 106 in order to improve the efficiency in selecting and updating context probability models. Upon receipt of an indication from context probability model selection module 105, context probability model cache 108 sends corresponding probability model to single bin decoding module 106.

Corresponding context probability models should be updated upon decoding of every bin, therefore 44 registers of 7 bits each are set up in context probability model cache 108 to avoid repeated accessing context probability models and writing updated context probability models in context probability model memory 104. The context probability models can be sorted into groups in the possible order according to which the context probability models are invoked. During the decoding process of a macroblock, every group of context probability models is loaded into the register groups only once, and after all context probability models are used, the context probability models are written back into the context probability model memory 104 only once. The total number of context probability models in a group does not exceed 44.

In an embodiment of the present invention, all context probability models are sorted into 18 groups on the basis of the order according to which syntax elements are invoked:
Group 1: mb_skip_flag;
Group 2: mb_field_decoding flag;
Group 3: mb_type for SI slice;
Group 4: mb_type for I slice;
Group 5: mb_type for P slice;
Group 6: mb_type for B slice;
Group 7: sub_mb_type for P slice;
Group 8: sub_mb_type for B slice;
Group 9: syntax elements for intra prediction mode, including prev_infla4x4 _pred_mode_flag,rem_intra4x4 _pred_mode, intra_chroma_pred_mode;
Group 10: ref_idx;
Group 11: abs_mvd;
Group 12: coded_block _pattern;
Group 13: mb_dq_delta;
Group 14: decoding DC coefficient intra16x16 mode coded_block_flag, significant_coeff_flag, last_significant_coeff_flag, coeff_abs_level_minus1;
Group 15: decoding AC coefficient intra16x16 mode coded_block_flag, significant_coeff_flag, last_significant_coeff_flag, coeff_abs_level_minus1 ;
Group 16: decoding coefficient non intra16x16 mode coded_block_flag, significant_coeff_Hag, last_significant_coeff_flag, coeff_abs_level_minus1;
Group 17: decoding DC coefficient chroma mode coded_block_flag, significant_coeff_flag, last_significant_coeff_flag,coeff_abs_level_minus1;
Group 18: decoding AC coefficient chroma mode coded_block_flag, significant_coeff_flag, last_significant_coeff_flag, coeff_abs_level_minus1.

It should be noted that the context probability models can be grouped flexibly as long as the context probability models needed for decoding a type of syntax elements can be accessed from context probability model cache 108.

Control unit 200 includes computer programs adapted to configure and controlling the CABAC decoding process in decoding unit 100. The computer programs are run on a central processing unit (CPU) or digital signal processor (DSP) and configure and control decoding unit 100 via interface unit 300, and particularly, the configuration and the controlling include:
(1) initializing decoding unit 100;
(2) configuring the information of the neighboring macroblock and bitstreams needed in the CABAC decoding process;
(3) accessing the decoding result from decoding unit 100; and
(4) sending a control signal to control decoding unit 100 to perform the CABAC decoding process.

According to an embodiment, before decoding macroblocks, control unit 200 checks whether decoding unit 100 need fill bitstreams, and if decoding unit 100 need fill bitstreams, the bitstreams are filled into corresponding modules before starting the decoding of macroblocks.

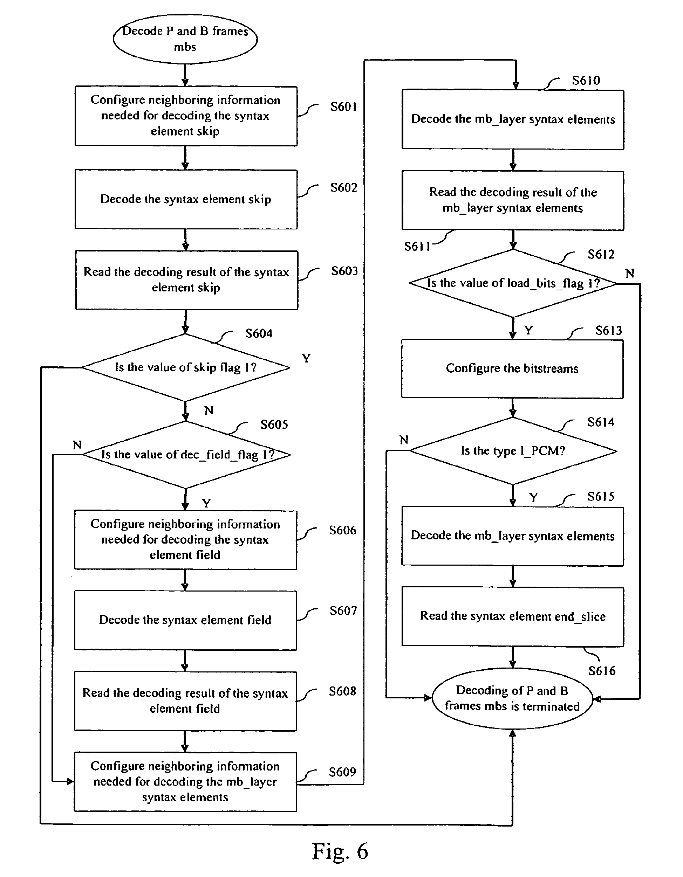

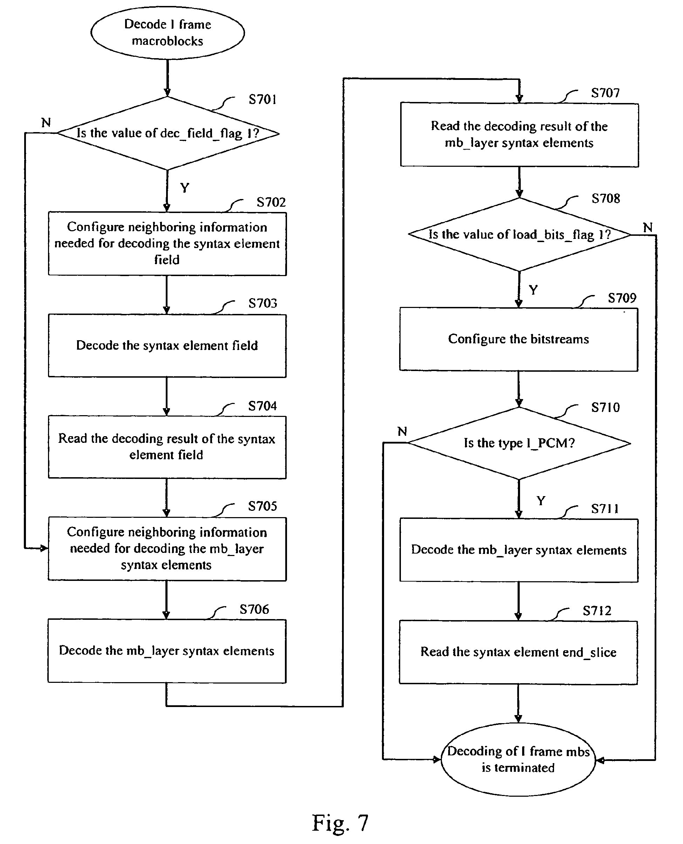

Figures 6 and 7 show the decoding flow of P, B and I slices performed by decoding unit 100 under the control of control unit 200.

The flow can be divided into two parts, in the first part, control unit 200 configures decoding unit 100, i.e., control unit 200 writes configuration data, bitstreams and control data into decoding unit 100; in the second part, control unit 200 reads data from decoding unit 100 and the data includes corresponding syntax elements obtained by decoding unit 100 according to the decoding configuration and control of control unit 200.

The configuration made by control unit 200 to decoding unit 100 includes the configuring decoding skip information, decoding field information and decoding mb_layer information and loading bitstreams. Control unit 200 reads data from decoding unit 100 by reading skip information, field information, mb_layer decoding information and end_slice information.

It can be seen from Figures 6 and 7 that the difference between the decoding of P and B slices and the decoding of I slices is that, in the decoding of P and B slices, the control over skip decoding is included in the configuration made by control unit 200 to decoding unit 100. If the skip value obtained by decoding is 1, the decoding of the whole macroblock layer is completed, otherwise the decoding process proceeds to other syntax elements in macroblock layer under the control similar to the control over the I slice decoding process.

The decoding process is described as follows with reference to P and B slices.

In block S601, control unit 200 configures the information of the neighboring macroblock needed for decoding syntax element skip in decoding unit 100 and sends a skip decoding start signal.

In block S602, upon receipt of the skip decoding start signal, decoding unit 100 starts decoding syntax element skip.

In block S603, control unit 200 reads from decoding unit 100 the result value of the decoding of skip.

In block S604, if control unit 200 determines that the skip value is 1, the decoding of the whole macroblock is terminated, otherwise block S605 is performed.

In block S605, control unit 200 determines whether syntax element field should be decoded, i.e., whether the value dec_field_flag is 1; if the value dec_field_flag is 1, block S606 is performed, otherwise block S609 is performed.

In block S606, control unit 200 configures the information of the neighboring macroblock needed for decoding field syntax element in decoding unit 100 and sends a field decoding start signal; the syntax element field is decoded in mbaff mode only when: the macroblock being decoded at present is the top macroblock of the macroblock pair, or, the macroblock being decoded at present is the bottom macroblock of the macroblock pair and the top macroblock of the macroblock pair is a skip macroblock.

In block S607, upon receipt of the field decoding start signal, decoding unit 100 starts decoding syntax element field.

In block S608, after decoding unit 100 has decoded the syntax element field, control unit 200 reads the result of the decoding of the syntax element field.

In block S609, control unit 200 configures the information of the neighboring macroblock needed for decoding mb_layer in decoding unit 100 and sends an mb_layer decoding start signal.

In block S610, upon receipt of the mb_layer decoding start signal, decoding unit 100 starts decoding mb_layer syntax elements.

In block S611, after decoding unit 100 has decoded the mb_layer syntax elements, control unit 200 reads the result of the decoding of the mb_layer syntax elements.

In block S612, decoding unit 100 determines whether the value of load_bits_flag is 1, i.e., whether bitstreams should be filled into decoding unit 100; if the value of load_bits_flag is 1, block S613 is performed, otherwise the whole process is terminated.

In block S613, decoding unit 100 enters internal interrupt and requests control unit 200 to fill bitstreams into decoding unit 100; after the bitstreams are filled, decoding unit 100 automatically deactivate the internal interrupt and resumes decoding. It should be noted that, when the decoding of mb_layer is completed, control unit 200 checks whether bitstream memory 1021 in decoding unit 100 is empty; if bitstream memory 1021 is empty, control unit 200 fills bitstreams into decoding unit 100 to make bitstream memory 1021 in decoding unit 100 full and reduce the frequent interruptions caused by the exhaustion of bitstreams during the decoding of mb_layer which decreases the decoding efficiency of decoding unit 100.

In block S614, if control unit 200 determines that the present macroblock obtained by decoding the mb_layer is in I_PCM type and control unit 200 learns that bitstreams are exhausted from decoding unit 100, the bitstreams corresponding to I_PCM on the outside of decoding unit 100 are reduced directly to macroblock images and the remaining bitstreams are filled into decoding unit 100, and bitstream memory 1021 in decoding unit 100 is regarded by default as empty.

In block S615, decoding unit 100 decodes the mb_layer syntax elements in the bitstreams newly filled by control unit 200.

In block S616, decoding unit 100 decodes syntax element end_slice; the syntax element end_slice is usually decoded in the mb_layer and read by control unit 200, however, when the macroblock is in type I_PCM, the end-slice is decoded after control unit 200 restores I_PCM data and fills bitstreams again into decoding unit 100. After decoding unit 100 completes the decoding, control unit 200 reads the syntax element end_slice.

Figure 7 shows the decoding flow for an I slice, and blocks S701 to S712 are correspondingly identical to blocks S605 to S616 described above and will not be described again.

Interface unit 300 is adapted to transmit interaction information between decoding unit 100 and control unit 200, including bitstreams, information of the neighboring macroblock and control signals to be configured for decoding unit 100 in the decoding process. The information of the neighboring macroblock includes:
(1) avaible_flag indicating whether neighboring macroblocks exist;
(2) skip_flag indicating whether neighboring macroblocks should be skipped;
(3) field_flag of neighboring macroblocks;
(4) mb_type flag and sub_mb_type flag of neighboring macroblocks;
(5) CBP flag and CBF flag of neighboring macroblocks;
(6) flag indicating whether neighboring macroblocks are intra macroblocks or inter macroblocks;
(7) chroma prediction mode flag of neighboring macroblocks;
(8) dquant flag of neighboring macroblocks;
(9) mvd and refframe of neighboring macroblocks;
(10) flag indicating whether the present slice is in mbaff mode;
(11) slice type flag indicating whether the present slice is an I slice, P slice or B slice;
(12) num_refidx0 minus1, num_refidx1_minus1, slice_data_partition and constrained_intra_predflag obtained by encoding the present slice header.

Interface unit 300 includes a series of registers and a group of memories RAMS. Interface unit 300 sets an address for every data filed in every register and memory, and control unit 200 interacts with interface unit 300 by accessing the addresses and reading and writing the data at the addresses.

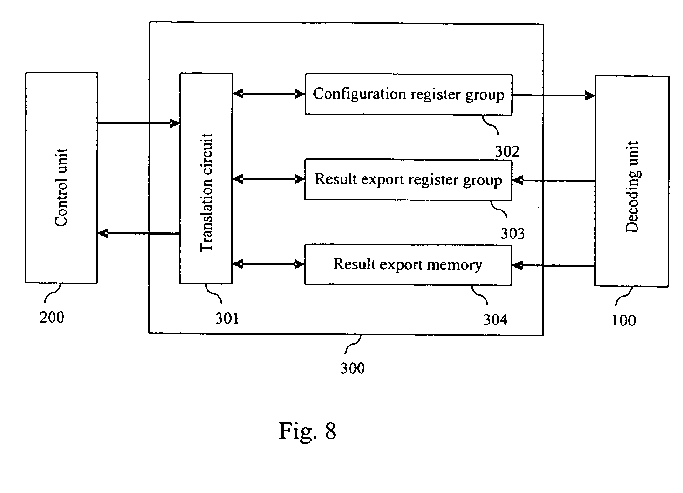

As shown in Figure 8, interface unit 300 further includes translation circuit 301, configuration register group 302, result export register group 303 and result export memory 304.

Translation circuit 301 is adapted to address translation between control unit 200 and interface unit 300 so that control unit 200 may read and write data on interface unit 300.

Configuration register group 302 saves the configuration information written by control unit 200 via translation circuit 301 for controlling decoding unit 100 in the decoding process.

Decoding unit 100 writes the decoding result into interface unit 300, in which MVD data and coeff data should be written into result export memory 304 while other syntax elements are written directly into result export register group 303. Control unit 200 reads the decoding result from decoding unit 100 by reading data at corresponding addresses.

It should be noted that, interface unit 300 may configure information of a neighboring macroblock in different ways: interface unit 300 may configure complete information of a macroblock above the present macroblock and macroblock to the left of the present macroblock; or interface unit 300 configures only information of the macroblock above the present macroblock while decoding unit 100 maintains the information of the macroblock to the left of the present macroblock; or interface unit 300 configures only control signals while decoding unit 100 maintains all reference syntax element information.

The above description is only preferred embodiments of the present invention but not limitative to the protection scope thereof. Those skilled in the art should recognize modifications, equivalent replacements or improvements of the present invention.

## Claims

1. A context-based adaptive binary arithmetic decoding apparatus, adapted to decode all syntax elements in the macroblock layer for bitstreams to be decoded, and send the syntax elements;
wherein the decoding apparatus comprises:
a decoding control unit (101), adapted to receive a decoding control signal and send the decoding control signal;
a decoding management unit, adapted to receive the decoding control signal from the decoding control unit (101) and decode all syntax elements in the macroblock layer for the bitstreams to be decoded, and send the syntax elements; and
a decoding information management unit, adapted to store context probability models, select a context probability model according to the information of a neighboring macroblock and information of a present macroblock for decoding a bin in the present syntax element, send the context probability model to the decoding management unit for decoding, receive the syntax elements from the decoding management unit and save the information of the syntax elements as the information of a neighboring macroblock of a follow-up macroblock to be decoded;
wherein the decoding management unit comprises:
a bitstream management module (102), adapted to receive the bitstreams and send the bitstreams;
a single bin decoding module (106), adapted to receive the bitstreams from the bitstream management module (102) and decode the bitstreams; and
a reassembly bin module (107), adapted to receive decoding results of the single bin decoding module (106), assemble the results of the single bin decoding module (106) into the syntax elements, output the syntax elements, and set information of syntax elements of the neighboring macroblock needed by the follow-up decoding process as the reference to the decoding of follow-up syntax elements; and
wherein the decoding information management unit comprises:
a context probability model memory (104), adapted to store the context probability models needed for decoding the syntax elements, receive a context probability model indication signal, and provide a context probability model for decoding a bin in the present syntax element for the decoding management unit according to the context probability model indication signal;
a neighboring macroblock information maintenance module (103), adapted to maintain information of the neighboring macroblock of the present macroblock being decoded; and
a context probability model selection module (105), adapted to select, according to the information of the neighboring macroblock and the information of the present macroblock, the context probability model for decoding the bin in the present syntax element, and send the context probability model indication signal to the context probability model memory (104);
**characterized in that** the decoding information management module further comprises:
a context probability model cache (108), adapted to cache the context probability models needed for decoding the syntax elements and send to the single bin decoding module (106) a context probability model corresponding the context probability model indication signal; and further to receive an updated context probability model from the single bin decoding module (106) and saving the updated context probability module into the context probability model memory (104); and
the context probability module cache (108) further includes a register group and the register group includes multiple registers adapted to buffer the context probability models needed by the single bin decoding module (106);
wherein the context probability models are sorted into groups in a possible order according to which the context probability models are invoked such that;
during the decoding process of a macroblock, every group of context probability models is loaded into the register groups only once and
after all the context probability models of a group are used, the context probability models of that group are written back into the context probability model memory (104) only once.

## Patentansprüche

1. Vorrichtung zur adaptiven binären arithmetischen Decodierung auf Kontextbasis, ausgelegt zum Decodieren aller Syntaxelemente in der Makroblockschicht für zu decodierende Bitströme und Senden der Syntaxelemente;
wobei die Decodiervorrichtung Folgendes umfasst:
eine Decodiersteuereinheit (101), ausgelegt zum Empfangen eines Decodiersteuersignals und Senden des Decodiersteuersignals;
eine Decodiermanagementeinheit, ausgelegt zum Empfangen des Decodiersteuersignals von der Decodiersteuereinheit (101) und Decodieren aller Syntaxelemente in der Makroblockschicht für die zu decodierenden Bitströme und Senden der Syntaxelemente; und
eine Decodierinformationsmanagementeinheit, ausgelegt zum Speichern von Kontextprobabilitätsmodellen, Auswählen eines Kontextprobabilitätsmodells gemäß den Informationen eines benachbarten Makroblocks und Informationen eines gegenwärtigen Makroblocks zum Decodieren eines Bin in dem gegenwärtigen Syntaxelement, Senden des Kontextprobabilitätsmodells an die Decodiermanagementeinheit zum Decodieren, Empfangen der Syntaxelemente von der Decodiermanagementeinheit und Sichern der Informationen der Syntaxelemente als die Informationen eines benachbarten Makroblocks eines zu decodierenden anschließenden Makroblocks;
wobei die Decodiermanagementeinheit Folgendes umfasst:
ein Bitstrommanagementmodul (102), ausgelegt zum Empfangen der Bitströme und Senden der Bitströme;
ein Einzel-Bin-Decodiermodul (106), ausgelegt zum Empfangen der Bitströme von dem Bitstrommanagementmodul (102) und Decodieren der Bitströme; und
ein Wiedervereinigungs-Bin-Modul (107), ausgelegt zum Empfangen von Decodierergebnissen des Einzel-Bin-Decodiermoduls (106), Vereinigen der Ergebnisse des Einzel-Bin-Decodiermoduls (106) zu den Syntaxelementen, Ausgeben der Syntaxelemente und Setzen von Informationen von Syntaxelementen des benachbarten Makroblocks, der von dem nachfolgenden Decodierprozess benötigt wird, als die Referenz zu dem Decodieren von nachfolgenden Syntaxelementen; und
wobei die Decodierinformationsmanagementeinheit Folgendes umfasst:
einen Kontextprobabilitätsmodellspeicher (104), ausgelegt zum Speichern der Kontextprobabilitätsmodelle, die für das Decodieren der Syntaxelemente benötigt werden, Empfangen eines Kontextprobabilitätsmodellanzeigesignals und Liefern eines Kontextprobabilitätsmodells für das Decodieren eines Bin in dem gegenwärtigen Syntaxelement für die Decodiermanagementeinheit gemäß dem Kontextprobabilitätsmodellanzeigesignal;
ein Benachbartes-Makroblock-Informationspflegemodul (103), ausgelegt zum Pflegen von Informationen des benachbarten Makroblocks des gegenwärtigen Makroblocks, der decodiert wird; und
ein Kontextprobabilitätsmodellauswahlmodul (105), ausgelegt zum Wählen, gemäß den Informationen des benachbarten Makroblocks und den Informationen des gegenwärtigen Makroblocks, des Kontextprobabilitätsmodells zum Decodieren des Bin in dem gegenwärtigen Syntaxelement und Senden des Kontextprobabilitätsmodellanzeigesignals an den Kontextprobabilitätsmodellspeicher (104);
**dadurch gekennzeichnet, dass** das Decodierinformationsmanagementmodul weiterhin Folgendes umfasst:
einen Kontextprobabilitätsmodellzwischenspeicher (108), ausgelegt zum Zwischenspeichern der zum Decodieren der Syntaxelemente benötigten Kontextprobabilitätsmodelle und Senden eines Kontextprobabilitätsmodells entsprechend dem Kontextprobabilitätsmodellanzeigesignal an das Einzel-Bin-Decodiermodul (106); und weiterhin zum Empfangen eines aktualisierten Kontextprobabilitätsmodells von dem Einzel-Bin-Decodiermodul (106) und Speichern des aktualisierten Kontextprobabilitätsmodells in dem Kontextprobabilitätsmodellspeicher (104); und
wobei der Kontextprobabilitätsmodellzwischenspeicher (108) weiterhin eine Registergruppe enthält und die Registergruppe mehrere Register enthält, ausgelegt zum Puffern der von dem Einzel-Bin-Decodiermodul (106) benötigten Kontextprobabilitätsmodelle;
wobei die Kontextprobabilitätsmodelle zu Gruppen in einer möglichen Reihenfolge sortiert werden, gemäß denen die Kontextprobabilitätsmodelle aufgerufen werden, so dass:
während des Decodierprozesses eines Makroblocks jede Gruppe von Kontextprobabilitätsmodellen nur einmal in die Registergruppen geladen wird und nachdem alle Kontextprobabilitätsmodelle einer Gruppe verwendet sind, die Kontextprobabilitätsmodelle der Gruppe nur einmal zurück in den Kontextprobabilitätsmodellspeicher (104) geschrieben werden.

## Revendications

1. Appareil de décodage arithmétique binaire adaptatif fondé sur le contexte conçu pour décoder tous les éléments de syntaxe dans une couche de macro-blocs pour des flux binaires à décoder et pour envoyer les éléments de syntaxe,
dans lequel l'appareil de décodage comprend :
une unité de commande de décodage (101), conçue pour recevoir un signal de commande de décodage et pour envoyer le signal de commande de décodage,
une unité de gestion de décodage, conçue pour recevoir le signal de commande de décodage provenant de l'unité de commande de décodage (101) et pour décoder tous les éléments de syntaxe dans la couche de macro-blocs pour les flux binaires à décoder, ainsi que pour envoyer les éléments de syntaxe, et
une unité de gestion d'informations de décodage, conçue pour mémoriser des modèles de probabilités de contextes, pour sélectionner un modèle de probabilité de contexte en fonction des informations d'un macro-bloc voisin et des informations d'un macro-bloc présent afin de décoder un fichier dans le présent élément de syntaxe, pour envoyer le modèle de probabilité de contexte à l'unité de gestion de décodage en vue d'un décodage, pour recevoir les éléments de syntaxe provenant de l'unité de gestion de décodage et pour sauvegarder les informations des éléments de syntaxe comme étant les informations d'un macro-bloc voisin d'un macro-bloc suivant à décoder,
dans lequel l'unité de gestion de décodage comprend :
un module de gestion de flux binaires (102), conçu pour recevoir les flux binaires et pour envoyer les flux binaires,
un module de décodage de fichier unique (106), conçu pour recevoir les flux binaires provenant du module de gestion de flux binaires (102) et pour décoder les flux binaires, et
un module de fichier de réassemblage (107), conçu pour recevoir les résultats de décodage du module de décodage de fichier unique (106), pour assembler les résultats du module de décodage de fichier unique (106) dans les éléments de syntaxe, pour fournir en sortie les éléments de syntaxe et pour établir des informations sur les éléments de syntaxe du macro-bloc voisin demandés par le processus de décodage suivant comme étant la référence au décodage des éléments de syntaxe suivants, et
dans lequel l'unité de gestion d'informations de décodage comprend :
une mémoire de modèles de probabilités de contextes (104) conçue pour mémoriser les modèles de probabilités de contextes demandés pour décoder les éléments de syntaxe, pour recevoir un signal d'indication de modèle de probabilité de contexte et pour fournir un modèle de probabilité de contexte afin de décoder un fichier dans le présent élément de syntaxe pour l'unité de gestion de décodage en fonction du signal d'indication de modèle de probabilité de contexte,
un module de maintenance des informations de macro-bloc voisin (103), conçu pour maintenir les informations du macro-bloc voisin du présent macro-bloc décodé, et
un module de sélection de modèle de probabilité de contexte (105) conçu pour sélectionner, en fonction des informations du macro-bloc voisin et des informations du présent macro-bloc, le modèle de probabilité de contexte pour décoder le fichier dans le présent élément de syntaxe et pour envoyer le signal d'indication de modèle de probabilité de contexte à la mémoire de modèles de probabilités de contextes (104),
**caractérisé en ce que** le module de gestion d'informations de décodage comprend en outre :
une mémoire cache de modèles de probabilités de contextes (108) conçue pour mettre en cache les modèles de probabilités de contextes demandés pour décoder les éléments de syntaxe et pour envoyer au module de décodage de fichier unique (106) un modèle de probabilité de contexte correspondant au signal d'indication de modèle de probabilité de contexte, et en outre pour recevoir un modèle mis à jour de probabilité de contexte provenant du module de décodage de fichier unique (106) et pour sauvegarder le module mis à jour de probabilité de contexte dans la mémoire de modèles de probabilités de contextes (104), et
la mémoire cache de modèles de probabilités de contextes (108) inclut en outre un groupe de registres, et le groupe de registres inclut de multiples registres conçus pour mettre en tampon les modèles de probabilités de contextes demandés par le module de décodage de fichier unique (106),
dans lequel les modèles de probabilités de contextes sont classés en groupes selon un ordre possible en fonction duquel sont invoqués les modèles de probabilités de contextes de telle sorte que :
pendant le processus de décodage d'un macro-bloc, tout groupe de modèles de probabilités de contextes n'est chargé qu'une fois dans les groupes de registres et après que tous les modèles de probabilités de contextes d'un groupe ont été utilisés, les modèles de probabilités de contextes de ce groupe ne sont réécrits qu'une fois dans la mémoire de modèles de probabilités de contextes (104).
